# EUROPÄISCHE PATENTANMELDUNG

(11) **EP 0 863 551 A2**
(43) Veröffentlichungstag der Anmeldung: **09.09.1998**
(21) Anmeldenummer: 98440043.2
(22) Anmeldetag: 04.03.1998
(51) Int. Cl.: H01L 23/66, H01L 23/06

(54) **Gehäuse für mikrooptische und/oder mikroelektronische Bauelemente**

(30) Priorität: 06.03.1997 DE 19709042
(71) Anmelder: Alcatel Alsthom Compagnie Generale d'Electricité, 75088 Paris (FR)
(72) Erfinder: Kaiser, Detlef, Dr., 49134 Wallenhorst (DE); Hirler, Hans-Peter, 73235 Weilheim a. d. Teck (DE)
(74) Vertreter: Schätzle, Albin, Dipl.-Phys.

(57) **Zusammenfassung**

Die Erfindung betrifft ein Gehäuse für mikrooptische und/oder mikroelektronische Bauelemente. Das Gehäuse soll in der Weise ausgebildet sein, daß durch im Gehäuse entstehende stehende Wellen ausgelöste Gehäuseresonanzen vollständig vermieden oder sehr stark bedämpft werden.

Das wird dadurch erreicht, daß das Gehäuse ganz oder teilweise aus einem mikrowellenabsorbierenden, nicht ausgasenden Werkstoff besteht. Als Werkstoff ist beispielsweise Silizium oder Graphit geeignet.

## Beschreibung

Die Erfindung betrifft ein Gehäuse für mikrooptische und/oder mikroelektronische Bauelemente.

Wenn die in einem Gehäuse vorhandenen elektronischen und/oder optoelektronischen Schaltungen bei Frequenzen im GHz-Bereich betrieben werden, dann kann ein Teil der Mikrowellenleistung ungewollt abgestrahlt werden. Die dabei entstehenden elektromagnetischen Schwingungen werden an den Innenflächen von metallischen Gehäusewänden nahezu vollständig reflektiert. Das Gehäuse bildet in Abhängigkeit von seinen Innenabmessungen einen Schwingkreis, welcher bei bestimmten Frequenzen einen unerwünschten Resonanzeffekt zeigt. So ist beispielsweise bei Versuchsmessungen an einem für die Aufnahme von elektrischen oder optoelektronischen Bauelementen vorgesehenen Gehäuse festgestellt worden, daß bei bestimmten Frequenzen - z.B. bei etwa 2,5 GHz, 8 GHz, 12 GHz, 17,5 GHz und etwa bei 21 GHz - scharfe Resonanzen auftreten. Das zeigt, daß ein nicht unerheblicher Teil der ins Bauelement zu transportierenden Mikrowellenleistung in eine Gehäuseresonanz gekoppelt wird, welche zu einer drastisch erhöhten oder auch erniedrigten Rückreflexion führt und somit auch entsprechend scharfe Variationen in der dem Bauelement zugeführten Leistung verursacht. Bei Schaltungen für digitale oder breitbandige analoge Anwendungen sind derartige Leistungsschwankungen nicht tolerierbar.

Das der Erfindung zugrunde liegende technische Problem besteht deshalb darin, ein Gehäuse zu schaffen, bei dem derartige Gehäuseresonanzen vollständig vermieden oder zumindest sehr stark bedämpft werden.

Dieses technische Problem ist erfindungsgemäß dadurch gelöst, daß das Gehäuse vollständig oder teilweise aus einem mikrowellenabsorbierenden, nicht ausgasenden Werkstoff besteht

Bei Messungen an Gehäusen, welche in der erfindungsgemäßen Weise ausgebildet waren, ist festgestellt worden, daß Gehäuseresonanzen praktisch nicht mehr vorhanden waren.

Die Absorberwerkstoffe sollten eine hohe Reinheit und eine mittlere spezifische Leitfähigkeit σ- = 1 -10 [1 /Ω • m] aufweisen. Bei Untersuchungen wurde Silizium mit einer relativen DK von 12 verwendet.

Ein geeigneter Beschichtungswerkstoff sind dünne Platten aus Silizium. Derartige Siliziumplatten sind handelsüblich. Sie sind einseitig mit einer Metallschicht, wie Gold und/oder Zinn, versehen und können daher an den Innenwänden eines metallischen Gehäuses durch Löten befestigt werden.

Ein anderer geeigneter Beschichtungswerkstoff ist eine Graphitfolie, wie sie beispielsweise von der Fa. SGL Technik GmbH unter der Warenbezeichnung "SIGRAFLEX" angeboten wird. Diese Folie kann auf den Innenflächen des Gehäuses mittels eines im Handel erhältlichen nicht ausgasenden Klebers befestigt werden. Graphit als Absorberwerkstoff erzielt wegen seiner hohen Wärmeleitfähigkeit eine doppelte Funktion, nämlich einerseits als Mikrowellenabsorber und andererseits als Wärmesenke.

## Patentansprüche

1. Gehäuse für mikrooptische und / oder mikroelektronische Bauelemente, dadurch gekennzeichnet, daß es vollständig oder teilweise aus mikrowellenabsorbierenden, nicht ausgasenden Werkstoffen besteht.

2. Gehäuse nach Anspruch 1, dadurch gekennzeichnet, daß es aus Graphit besteht.

3. Gehäuse nach Anspruch 1, dadurch gekennzeichnet, daß es aus Silizium besteht.

4. Gehäuse nach Anspruch 1, dadurch gekennzeichnet, daß es aus Metall besteht und die Innenwände mit einem mikowellenabsorbierenden, nicht ausgasenden Werkstoff beschichtet sind.

5. Gehäuse nach Anspruch 4, dadurch gekennzeichnet, daß die Innenbeschichtung aus Silizium besteht.

6. Gehäuse nach Anspruch 4, dadurch gekennzeichnet, daß die Innenbeschichtung aus einer Graphitfolie besteht.

7. Gehäuse nach Anspruch 4, dadurch gekennzeichnet, daß die Innenbeschichtung aus Verbindungen von Silizium mit Elementen der 2. Periode des periodischen Systems der Elemente besteht z.B. Siliziumkarbid, Siliziumnitrid und Siliziumoxide.
